**Europäisches Patentamt**

**European Patent Office**

**Office européen des brevets**

(19)

(11) Veröffentlichungsnummer: **0 151 478**
**B1**

(12)

# EUROPÄISCHE PATENTSCHRIFT

(45) Veröffentlichungstag der Patentschrift:
**03.08.88**

(51) Int. Cl.⁴: **H 05 K 7/18, A 47 B 47/00**

(21) Anmeldenummer: **85101090.0**

(22) Anmeldetag: **02.02.85**

(54) Schrank zur Aufnahme von elektrischen Bauteilen.

(30) Priorität: **08.02.84 DE 3404349**

(43) Veröffentlichungstag der Anmeldung:
**14.08.85 Patentblatt 85/33**

(45) Bekanntmachung des Hinweises auf die Patenterteilung:
**03.08.88 Patentblatt 88/31**

(84) Benannte Vertragsstaaten:
**AT BE CH DE FR GB IT LI LU NL SE**

(56) Entgegenhaltungen:
**AT - A - 304 001
DE - A - 2 654 590
FR - A - 1 386 976**

(73) Patentinhaber: **Licentia Patent-Verwaltungs-GmbH,
Theodor-Stern-Kai 1, D-6000 Frankfurt/Main 70 (DE)**

(72) Erfinder: **Bohnenberger, Willy, Dipl.-Ing.,
Goethestrasse 8, D-6451 Mainhausen 2 (DE)**
Erfinder: **Dierks, Jens-Uwe, Dipl.-Ing., Tizianstrasse 41,
D-2350 Neumünster (DE)**
Erfinder: **Günther, Albin, Dipl.-Ing., Padenstedter
Landstrasse 45, D-2350 Neumünster (DE)**
Erfinder: **Halm, Kurt, Hochstrasse 11 d,
D-1000 Berlin 65 (DE)**
Erfinder: **Haxel, Gerd, Ing.(grad), Danziger Strasse 38,
D-6453 Seligenstadt (DE)**
Erfinder: **Mai, Stephan, Schlehnstrasse 22,
D-2350 Neumünster (DE)**
Erfinder: **Sabisch, Siegfried, Dipl.-Ing.,
Immanuel-Kant-Strasse 5, D-6239 Kriftel (DE)**

(74) Vertreter: **Lertes, Kurt, Dr. et al, Licentia
Patent-Verwaltungs-GmbH Theodor-Stern-Kai 1,
D-6000 Frankfurt/M 70 (DE)**

## Beschreibung

Die Erfindung bezieht sich auf eine Schranke zur Aufnahme von Einsätzen, Einschüben und Geräten, die elektrische und/oder elektronische Bauelemente aufweisen, mit einem Rahmengestell aus mindestens zwölf miteinander verbundenen Rahmenschenkeln aus Profilstäben, die den gleichen Querschnitt haben und als quadratische Hohlkörper ausgebildet sind, die auf mindestens einer Längsseite eine sich in Längsrichtung erstreckende, rechtwinklig vorspringende Leiste aufweisen, die mit einer Reihe von Löchern versehen ist, an denen die Einsätze, Einschübe oder Geräte gegebenenfalls über Anschlußelemente befestigbar sind.

Ein derartiger Schrank ist bereits bekannt (US-PS 3 087 768). An der vorspringenden Leiste sind die Schrankwände und die Einbauteile anschraubbar. Die Rahmenschenkel sind an ihren Enden auf Eckelemente aufgesteckt, die drei in zueinander senkrechte Richtungen verlaufende Profilvorsprünge haben.

Bekannt ist auch ein Schrank, dessen Wände an den vertikalen Rändern zur Versteifung U-förmig umgebogen sind. Die Ränder sind mit Schlitzen zur Befestigung von Scharnieren versehen (DE-AS 15 91 623).

Schließlich ist ein Schrank bekannt, der für die vertikalen und horizontalen Rahmenschenkel unterschiedliche Profile hat. Die Profile der vertikalen Rahmenschenkel sind mit einer nur für die Befestigung eines sich über die gesamte Höhe erstreckenden Scharniers bestimmt (US-PS 3 178 246).

Der Erfindung liegt die Aufgabe zugrunde, einen Schrank der eingangs beschriebenen Gattung dahingehend weiterzuentwickeln, daß an den Leisten der Profilstäbe sowohl Wände als auch Scharniere und/oder Anschläge für Türen bei gleichzeitiger Verfügbarkeit der vollen Länge der Profilstäbe für den Einbau der Einsätze, Einschübe und Geräte befestigbar sind.

Die Aufgabe wird erfindungsgemäß durch die im Anspruch 1 beschriebenen Maßnahmen gelöst. Für den Tragrahmen werden bei diesem Schrank einfache Profilstäbe verwendet, die sich in Standardlängen herstellen und auf die gewünschten Längen abschneiden lassen. Die Wände, die Tür und die Einbauteile werden an den Leisten der Profilstäbe angeschraubt. Für die Montage der Schränke sind daher nur einfache Handgriffe und keine aufwendigen Maschinen notwendig. Bei der Projektierung des Innenausbaus des Schrankes sind keine Einschränkungen hinsichtlich des Platzbedarfs der Befestigungsmittel von Wänden oder Türen zu beachten. Dies erleichtert die Planung des Innenausbaus und die Ausgabe von Einbauanweisungen mittels CAD. Die Scharnierteile können daher leicht und schnell an den vertikalen Profilstäben befestigt werden. Vorzugsweise enthalten mit dem Schrank starr verbundene Anschläge für die Riegel von Schlössern dem Umriß der Profilstäbe angepaßte, bis zu den Leisten der Profilstäbe verlaufende Abschnitte, die auf der dem Schrankinneren zugewandten Seite der Leisten je an einem Loch der zweiten Reihe angeschraubt sind. Scharnierteile und Anschläge lassen sich auf die gleiche Art mit den vertikalen Profilschienen verbinden.

Vorzugsweise beträgt das Rastermaß der ersten Lochreihe, die in der Leiste zwischen der zweiten Lochreihe und dem Hohlprofil angeordnet ist, fünfundzwanzig Millimeter. In den Schrank können deshalb vorzugsweise Geräte bzw. Bauteile eingefügt werden, deren Abmessungen dem modularen Raster von fünfundzwanzig mm entsprechen. In der «Modulordnung für elektrische Schaltanlagen» DIN 43355 und der «Bauweise für elektronische Einrichtungen, Modulordnung» DIN 43355 Entwurf sind 25 mm als Multimodule festgelegt. Zweckmäßigerweise sind die Hohlprofile rechteckig oder quadratisch ausgebildet. Die Profilstäbe lassen sich aus Bändern durch Profilieren und Stanzen kostengünstig herstellen.

Bei einer bevorzugten Ausführungsform sind als Zwischenträger ein oder zwei Profilstäbe nebeneinander vertikal an ihren Enden mit horizontalen Profilstäben durch Formstücke verbunden, die je einen in den Hohlraum des Profilstabs formschlüssig hineinragenden Zapfen mit einem Basisteil aufweisen, das sowohl an der Leiste des horizontalen als auch an der Leiste des vertikalen Profilstabs angeschraubt ist. Diese Ausführungsform ermöglicht den Aufbau von breiten Schränken, die keine Zwischenwände aufweisen. Die Breite läßt sich durch entsprechend abgeschnittene Profilstäbe auswählen. Um die Stabilität eines breiteren Schranks zu gewährleisten, können in bestimmten Abständen, z.B. in Türbreite, die einzelnen Profilstäbe oder Paare von Profilstäben an der Vorder- und der Rückseite angebracht werden. Die Formstücke enthalten bei Profilstäben mit rechteckigen oder quadratischen Hohlräumen entsprechend geformte Zapfen, die mit einer Platte verbunden sind, von der eine Leiste ausgeht, die in ihrer Breite dem Abstand zwischen der Leiste und der Kante des Hohlprofils angepaßt ist. Über diese Leiste ist das Formstück an der Leiste des horizontalen Profilstabs angeschraubt.

Zweckmäßigerweise sind Anschlußelemente für die Verbindung der Leisten der Profilstäbe mit Einbaugeräten oder Einbaugeräteträgern an ihren Enden um die Stärke der Leisten der Profilstäbe abgekröpft, wobei die abgekröpften Enden jeweils mindestens zwei Lappen aufweisen, die durch einen Löcher der ersten Reihe freigebenden Abstand voneinander getrennt und an der dem Schrankinneren abgewandten Seite der Leisten mittels der Löcher der zweiten Reihe angeschraubt sind. Die Anschlußelemente können vorzugsweise Tragschienen für elektrische oder elektronische Einbauteile sein. Es ist günstig, wenn diese Tragschienen in dem gleichen Rastermaß wie die Profilstäbe mit Löchern versehen sind, die in der Höhe von entsprechenden Löchern der ersten Reihe der Leisten an den Profilschienen liegen. Damit lassen sich Geräte, Einschübe oder Einsätze, deren Abmessungen auf das Rastermaß abgestimmt sind, in unterschiedlichen Größen an den gleichen Tragschienen befestigen. Die Anzahl der für die Befestigung von Geräten, Einschüben oder Einsätzen notwendigen Teile wird hiermit wesentlich reduziert.

Bei einer vorteilhaften Ausführungsform ist vorgesehen, daß eine über einen abgebogenen Rand der scharnierlosen vertikalen Seite einer Tür hinausragende Anschlagleiste an einer Halteleiste für eine Türdichtung angeschraubt und mit einem Ende an der Türinnenfläche abgestützt ist und daß der über die Tür hinausragende Teil der Anschlagleiste in Schließstellung an den abgebogenen Rand der scharnierlosen vertikalen Seite einer zweiten Tür angelehnt ist, die ein Schloß aufweist, dessen Riegel in Schließstellung gegen einen abgekröpften Vorsprung der Anschlagleiste andrückbar ist. Mit der Anschlagleiste kann eine Tür bedarfsweise mit den für Doppeltüren notwendigen Teilen ausgestattet werden. Die Anschlagleiste ermöglicht die Verwendung hintergreifender Doppeltüren. Der Abstützabschnitt der Anschlagleiste ist vorzugsweise als rechteckiges oder quadratisches Hohlprofil ausgebildet, das gegen das Schrankinnere eine längliche, an den Rändern mit Vorsprüngen versehene Öffnung hat. In das Hohlprofil können Muttern oder Leisten mit Gewindebohrungen eingesetzt werden, an denen sich Schaltplantaschen oder rückwärtige Gehäuseabdeckungen von Geräten anschrauben lassen, die in der Tür angeordnet sind.

Bei einer günstigen Ausführungsform sind an den Leisten der horizontalen Profilstäbe auf der dem Schrankinneren abgewandten Seite Verstärkungsleisten angeschraubt, die in der Stärke dem Abstand zwischen der Leiste und der Kante des jeweiligen Profilstabs angepaßt sind und die auf ihrer dem Profilstab zugewandten Seite einen zurückgesetzten Abschnitt mit einem längs der Kante verlaufenden Vorsprung aufweisen, wobei in den zurückgesetzten Abschnitt eine Feder eingelegt ist, die einen aus dem Abschnitt herausragenden abgewinkelten Abschnitt enthält, der im Abstand vor der Profilleiste angeordnet ist und einen Schenkel einer Beschriftungsleiste an der Profilleiste anklemmt. Vorzugsweise enthält die Feder mindestens einen abgebogenen Lappen, der sich im zurückgesetzten Abschnitt am Vorsprung abstützt. Die Feder wird daher im zurückgesetzten Abschnitt unverlierbar gehalten. Mittels der Feder werden Beschriftungs- oder Zierleisten, die keinen großen Beanspruchungen ausgesetzt sind, an der Außenseite des Schrankes angeklemmt. Es ist günstig, wenn der vor dem Profilstab angeordnete abgewinkelte Abschnitt nahe an seinem Ende einen Vorsprung aufweist, der in Nuten des Schenkels einrastet. Auf diese Weise wird die Festigkeit der Verbindung erhöht bzw. die Lagefixierung auch bei geringen Anpreßkräften gewährleistet. Die Beschriftungs- oder Zierleiste hat zweckmäßigerweise eine ebene Frontfläche, von der nicht nur der vorzugsweise L-förmige Schenkel, sondern auch ein Abstützträger ausgeht, der an die Verstärkungsleiste angelehnt ist. Durch die zwei im Abstand voneinander angeordneten Anpreßstellen wirkt ein gleichmäßiger Anpreßdruck auf die jeweilige Beschriftungs- oder Zierleiste.

Eine weitere bevorzugte Ausführungsform besteht darin, daß an den Leisten der vertikalen Profilstäbe und/oder an zwischen den Profilstäben angeordneten Anschlußelementen Z-förmig gebogene Winkel an einer Seite angeschraubt sind, deren andere Seite jeweils in einer Nut einer Führungsschiene angeordnet ist, die Einschübe, Einsätze oder Geräte trägt. Die Führungsschiene läßt sich bei eingebautem Winkel in axialer Richtung in eine gewünschte Position verschieben und in dieser arretieren. Daher kann die Position der Führungsschienen den Abmessungen der von dieser zu tragenden Einbauteile angepaßt werden. Die beiden äußeren Abschnitte des Winkels verlaufen vorzugsweise nicht parallel, sondern in zueinander geneigten Ebenen. Beim Anschrauben der Winkel an den Leisten der Profilstäbe verkanten sich die anderen Abschnitte in den Nuten der Führungsschienen und arretieren diese deshalb in ihrer jeweiligen Stellung.

Bei einer sehr zweckmäßigen Ausführungsform ist an der Innenseite nahe am oberen oder unteren Rand einer Tür des Schrankes eine Führungsschiene befestigt, in deren Führungsbahn ein am Ende eines Hebelarms befestigter Bolzen verschiebbar angeordnet ist, wobei der Hebelarm an einem vertikalen Profilstab oder an einer Verstärkungsleiste in einer horizontalen Ebene schwenkbar gelagert ist und wobei der Bolzen einen über die Führungsschiene hinausragenden Kopf aufweist, der in eine am Ende der Führungsbahn angeordnete Wölbung einer Blattfeder einrastbar ist. Mit dieser Vorrichtung läßt sich die Tür in einer bestimmten Öffnungsstellung arretieren, die von der Länge des Hebelarms, der Führung und vom Abstand der Schwenkachse des Hebelarms von den Scharnieren abhängt. Es handelt sich um eine Arretierung mittels Federdruck, die bei Ausübung einer die Federkraft übersteigenden Kraft wieder gelöst wird.

Mit Hilfe der Blattfeder können Feststellmechanismen, die eine Schiene und einen Hebelarm aufweisen, der in der Öffnungsstellung mit einem Fallstift arretiert wird, leicht und schnell auf eine Federdruckarretierung umgestellt werden. Es ist lediglich die Blattfeder am Ende der Schiene anzuordnen. Der Fallstift kann durch einen Schraubenbolzen mit normalem Sechskantkopf ersetzt werden. Es entfällt bei der Druckfederarretierung das umständliche Lösen der Tür aus der Arretierstellung. Außerdem können die Teile für die Druckfederarretierung oben und unten an der Tür befestigt sein, was bei der Fallstiftarretierung nicht möglich ist, weil sich der Fallstift nur unten wieder leicht lösen läßt.

Eine weitere günstige Ausführungsform besteht darin, daß vertikale, in axialer Richtung mittels eines Schlüssels verschiebbare Stangen je an einem Ende im Schloß und am anderen Ende in einem wenigstens einen Halbkreis beschreibenden Lappen eines Führungskörpers gelagert sind, der gabelförmig gebogene Enden aufweist, die an einer Seite in eine horizontale mit der Tür verbundene Halteleiste für Dichtungen eingesteckt ist, während der vertikale Rand an der vertikalen Halteleiste angeschraubt ist. Mit dieser Vorrichtung lassen sich die für die obere und untere Verriegelung einer Tür erforderlichen Stangen leicht und schnell an der Tür einlegen.

Die Erfindung wird im folgenden anhand eines in einer Zeichnung dargestellten Ausführungsbeispiels näher erläutert, aus dem sich weitere Merkmale sowie Vorteile ergeben. Es zeigen:

Fig. 1 eine perspektivische Ansicht eines Schranks ohne Tür und ohne eine der Seitenwände,

Fig. 2 eine Ansicht von vorne einer Eckverbindung zwischen zwei Profilschienen des Schranks gemäß Fig. 1,

Fig. 3 eine Ansicht von vorne zweier nebeneinander als Verstärkungsstreben angeordneter vertikaler Profilschienen, die mittels Formstücken an einer horizontalen Profilschiene befestigt sind,

Fig. 4 die in Fig. 3 dargestellte Vorrichtung im Querschnitt längs der Linien I–I,

Fig. 5 einen Schnitt längs der Linien II–II durch die in Fig. 4 gezeigte Anordnung,

Fig. 6 einen Querschnitt längs der Linien III–III des in Fig. 1 dargestellten Schranks,

Fig. 7 einen Querschnitt längs der Linien IV–IV des in Fig. 1 dargestellten Schranks,

Fig. 8 einen Querschnitt durch eine andere Form eines Profilstabs, an dem ein Scharnierteil befestigt ist,

Fig. 9 einen Querschnitt durch eine andere Form eines Profilstabs, dem ein Anschlag befestigt ist,

Fig. 10 einen Querschnitt durch die aneinandergrenzenden Ränder zweier Türen, die sich in Schließstellung befinden,

Fig. 11 einen Querschnitt durch einen vertikalen Profilstab mit Verstärkungs- und Beschriftungsleiste,

Fig. 12 eine Ansicht von oben einer mit Profilstäben verbundenen Führungsschiene,

Fig. 13 einen Querschnitt durch die in Fig. 12 dargestellte Führungsschiene,

Fig. 14 einen Schnitt längs der Linie V–V der in Fig. 12 dargestellten Anordnung,

Fig. 15 eine Ansicht eines Z-förmig gebogenen Winkels von der Seite,

Fig. 16 eine Ansicht einer Türfeststellanordnung von der Seite,

Fig. 17 die Vorrichtung gemäß Fig. 16 von oben,

Fig. 18 einen Schnitt längs der Linien VI–VI der in Fig. 16 dargestellten Vorrichtung,

Fig. 19 eine Ansicht der Türfeststellanordnung gemäß Fig. 16 in Öffnungsstellung der Tür,

Fig. 20 eine Ansicht einer Türverriegelungsanordnung von der Seite,

Fig. 21 einen Querschnitt durch den in Fig. 20 dargestellten Führungskörper,

Fig. 22 eine Ansicht des in Fig. 20 dargestellten Führungskörpers von vorne.

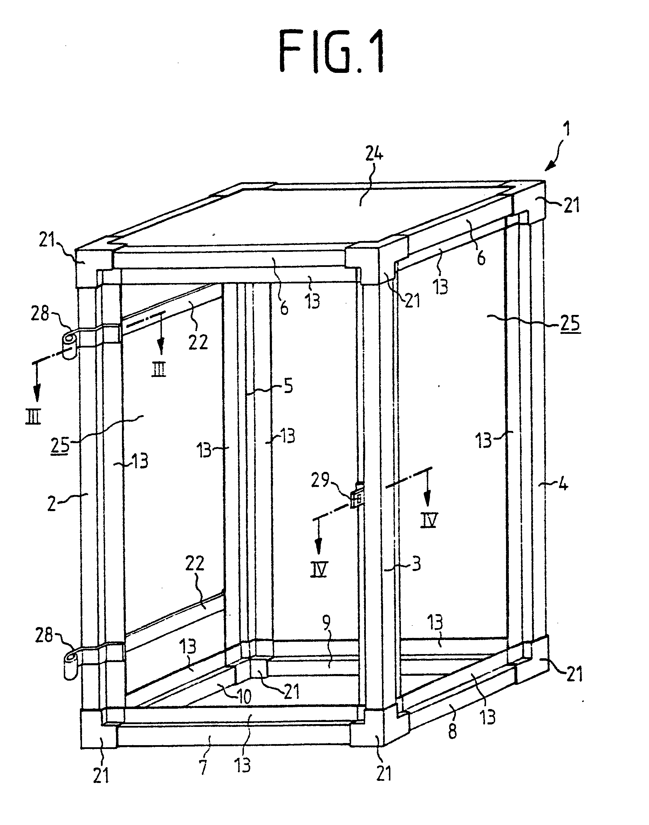

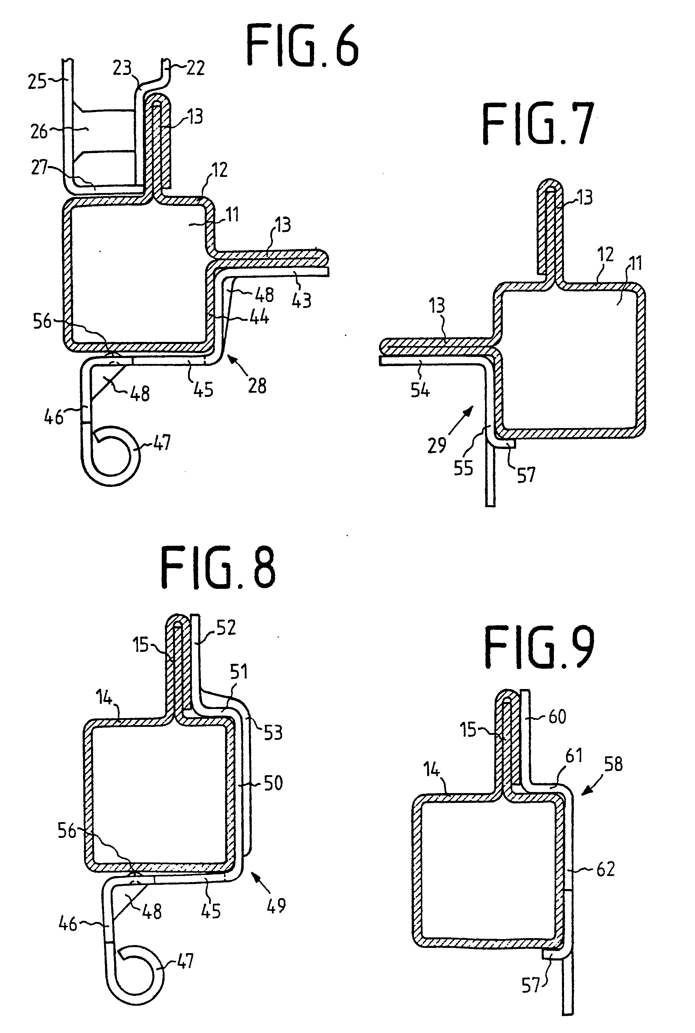

Ein Schrank 1 zur Aufnahme von Einsätzen, Einschüben und Geräten mit elektrischen und/oder elektronischen Bauelementen enthält einen Tragrahmen aus vier vertikalen Profilstäben 2, 3, 4, 5, vier horizontalen Profilstäben 6, die die vertikalen Profilstäbe 2, 3, 4, 5 an ihren oberen Enden miteinander verbinden, und vier horizontalen Profilstäben 7, 8, 9, 10, die die vertikalen Profilstäbe 2, 3, 4, 5 an ihren unteren Enden miteinander verbinden. Die Profilstäbe 2 bis 10 haben alle den gleichen Querschnitt und bestehen aus profiliertem Blech. Sie unterscheiden sich nur in ihrer Länge, wobei die vertikalen Profilstäbe 2 bis 5 und die horizontalen Profilstäbe 6 bis 10 jeweils gleich lang sind. Der Querschnitt der Profilstäbe 2 bis 10 geht aus Fig. 6 und Fig. 7 hervor. Die Profilstäbe 2 bis 10 haben einen quadratischen Hohlkörper 11, wobei wenigstens von einer Längsseite 12 eine Leiste 13 vorspringt. Bei den in Fig. 1, 6 und 7 dargestellten Profilstäben 2 bis 10 sind zwei Leisten 13 auf zwei aneinandergrenzenden Längsseiten vorhanden. Die in Fig. 8 und 9 dargestellten Profilstäbe 14 haben nur eine von einer Längsseite vorspringende Leiste 15. Die Leisten 13, 15 sind durch Umbördeln des einen Längsrands eines Blechstreifens über den anderen Längsrand hergestellt.

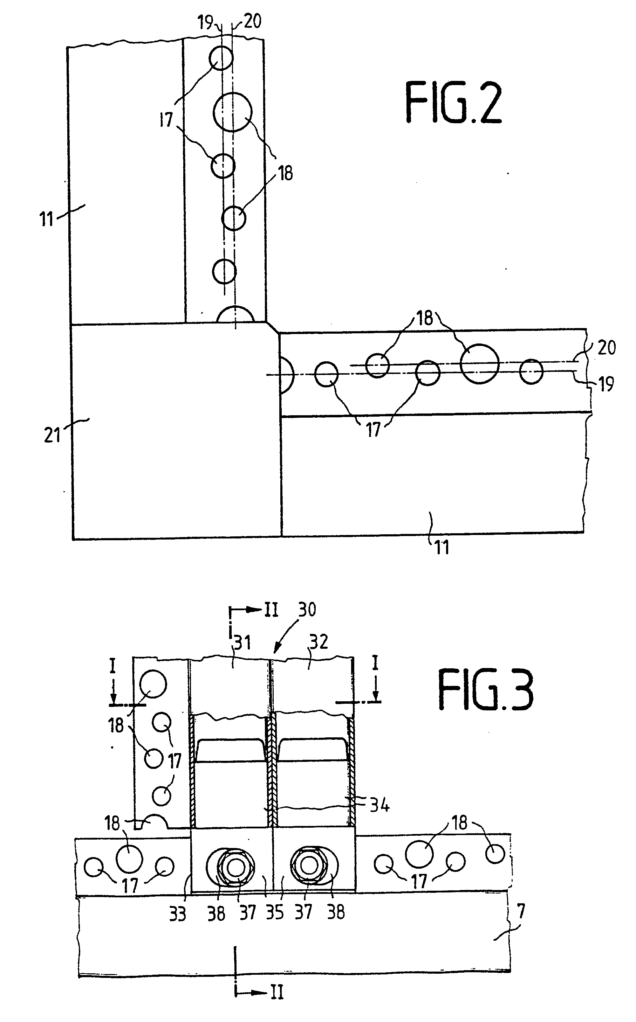

Auf den Leisten 13, 15 befinden sich zwei Reihen von Löchern 17, 18. Dies ist insbesondere aus den Fig. 2 und 3 zu ersehen. Die Löcher 17 sind gleich groß und befinden sich näher am Hohlkörper als die Löcher 18, die unterschiedliche Durchmesser aufweisen können. Die Löcher 17 sind längs einer Linie 19 angeordnet, die sich parallel zu dem Hohlkörper 11 erstreckt. Die Löcher 18 sind ebenfalls längs einer Linie 20 angeordnet, die parallel zu der Linie 19 verläuft. Die Abstände der Mitten der Löcher 17 sind durch ein Rastermaß festgelegt, das vorzugsweise 25 mm beträgt. Die Löcher 18 sind im gleichen Rastermaß angeordnet. In Längsrichtung der Leisten 13, 15 sind die Löcher 17, 18 gegeneinander um eine halbe Teilung des Rastermaßes versetzt.

Die Profilstäbe 2 bis 10 sind an ihren Enden rechtwinklig abgeschnitten. Zum Verbinden von vertikalen und horizontalen Profilstäben sind Eckverbinder 21 vorgesehen, die drei in Richtung der Koordinaten eines dreidimensionalen kartesischen Koordinatensystems verlaufende Zapfen aufweisen, die in die Hohlräume dreier mit ihren Enden aneinandergrenzender Profilstäbe 2, 6; 3, 6; 4, 6; 2, 7, 10; 3, 7, 8; 5, 9, 10 bzw. 4, 8, 9 ragen. Die Löcher 17 sind für die Befestigungen von Einschüben, Einsätzen bzw. Geräten oder deren Anschlußelementen vorgesehen. Als Anschlußelemente sind unter anderem Querträger 22 vorgesehen, die abgekröpfte Enden 23 aufweisen, deren Kröpfung der Stärke der Leisten 13, 15 entspricht. Die abgekröpften Enden 23 sind auf der dem Schrankinneren abgewandten Seite an die Leisten 13, 15 angeschraubt. Zur Befestigung werden vorzugsweise selbstschneidende Schrauben verwendet, wobei die Löcher 17, 18 ohne Gewinde ausgeführt sind. Dies hat den Vorteil, dass die Löcher 17, 18 gestanzt werden können und eine weitere Bearbeitung der Löcher 17, 18 entfällt. An den Leisten 13, 15 sind auch die Seiten- und Rückwände 25, das Dach 24 und gegebenenfalls ein nicht näher bezeichnetes Bodenteil befestigt. Als Befestigungsmittel für die Wände 24, 25 und das Bodenteil, die vorzugsweise aus Blech bestehen, sind nicht näher dargestellte Schrauben vorgesehen, die in Löcher der jeweiligen Wand eingesetzt werden und über Zwischenstücke 26 in die Löcher 18 der Leisten 13, 15 eingeschraubt sind. Die Zwischenstücke 26 sind erforderlich, wenn die Wände 24, 25 und das Bodenteil abgebogene Ränder 27 aufweisen. An den Löchern 18 der zweiten Reihe sind auch Scharnierbeschläge 28 und Türanschläge 29 angeschraubt.

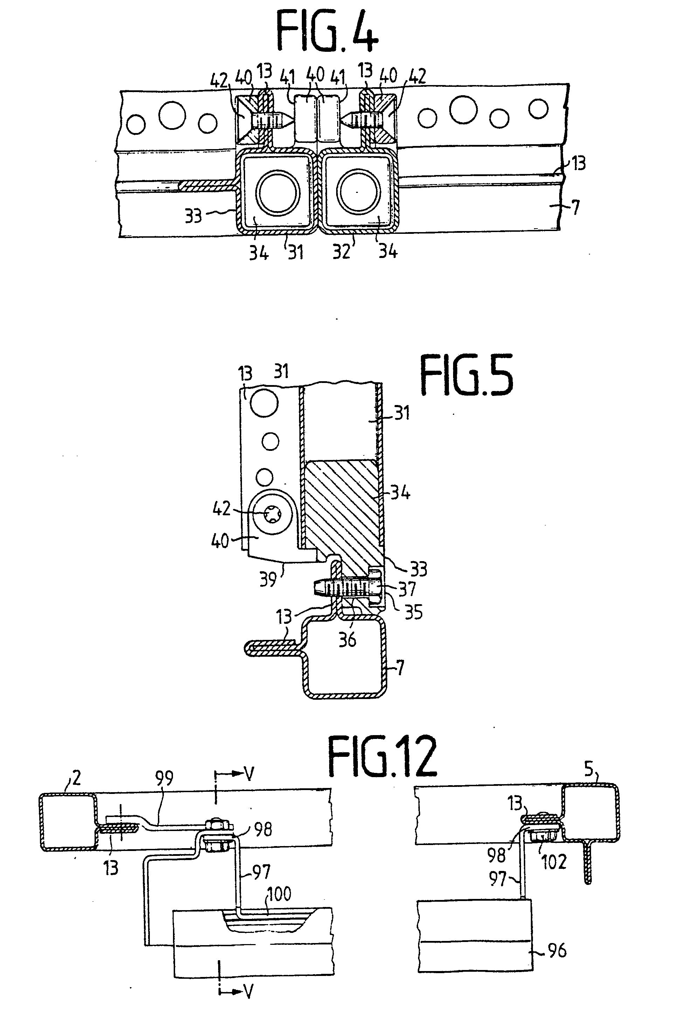

Die Profilstäbe 2 bis 10 werden in ihrer Länge auf die gewünschte Größe des Schranks 1 abgestimmt. Bei breiten Schränken ist es günstig, Zwischenträger 30 vorzusehen, die aus einem oder zwei nebeneinander angeordneten vertikalen Profilstäben 31, 32 bestehen, die im Aufbau mit den Profilstäben 2 bis 10 übereinstimmen. Die Profilstäbe 31, 32 sind an ihren Enden mittels Formstücken 33 an einen horizontalen Profilstab 6, 7, 8, 9 oder 10 angeschlossen. In Fig. 3, 4 und 5 ist der horizontale Profilstab 7 dargestellt.

Das Formstück 33 besteht aus einem Zapfen 34 mit quadratischem oder rechteckigem Querschnitt und einem Basisteil 35. Der Zapfen 34 ist an den Querschnitt des Hohlraums des jeweiligen Profilstabs 31, 32 angepaßt und ragt in diesen Hohlraum hinein. Das Basisteil 35 weist einen nicht näher bezeichneten Abschnitt auf, dessen Stärke dem Abstand zwischen der Kante des Profilstabs 7 und der Leiste 13 entspricht. Im Basisteil 35 ist ein Langloch 36, das sich in horizontaler Richtung erstreckt. In das Langloch 36 ist eine Schraube 37 eingesetzt, mit der das Basisteil an der Leiste 13 angeschraubt ist. Der Kopf der jeweiligen Schraube 37 ist versenkt im Basisteil 35 angebracht. Deshalb ist in Fig. 3 nicht das Langloch 36, sondern eine längliche Aussparung 38 sichtbar, in die jeweils der Kopf der Schraube 37 eingesetzt ist.

Vom Basisteil 34 ragt ein Vorsprung 39 in Richtung der Leiste des Profilstabs 31 bzw. 32. Der Vorsprung 39 gabelt sich in zwei zueinander parallele Zungen 40, die durch einen Abstand voneinander getrennt sind, in den die Leiste 13 ragt. Die Zungen 40 weisen parallel zu der Leiste 13 verlaufende Anschlagflächen 41 und nicht näher bezeichnete Löcher auf, die mit jeweils dem untersten Loch 17 der ersten Reihe fluchten. Die Stärke der Zungen 40 ist dem Abstand zwischen der Leiste 13 und der Kante des Profilstabs 31 bzw. 32 angepaßt. Die Zungen 40 sind mit Schrauben 42 an den Leisten 13 befestigt. Die Formstücke 34 weisen zwei Zungen 40 auf, da je nach der Lage des Formstücks 34 im Zwischenträger 30 entweder die rechte oder die linke Zunge an der außermittig verlaufenden Leiste 13 des Profilstabs 31 bzw. 32 anliegt. Die Langlöcher 36 sind vorhanden, um die Zungen 40 durch eine Verschiebung der Formstücke 33 an die Leisten 13 und die Profilstäbe 31, 32 aneinanderdrücken zu können.

Die Scharnierteile 28 sind jeweils dem Umriß der Profilschiene 2, 3, 4 bzw. 5 angepaßt. Bei Profilstäben 2 bis 5 mit zwei Leisten 13 bestehen die Scharnierteile 28 aus vier Abschnitten 43, 44, 45, 46, die jeweils der Leiste 13 und zwei Seitenwänden der Profilleiste gegenüberstehen bzw. von der einen Seitenwand des Profilstabs abstehen. Der Abschnitt 46 enthält ein zylindrisch gekrümmtes Zapfenaufnahmeteil 47. Vorzugsweise sind zwischen den Abschnitten 43, 44 und den Abschnitten 45, 46 Verstärkungswinkel 48 vorgesehen.

Wenn ein Profilstab 14 mit nur einer Leiste 15 verwendet wird, dann muß ein an die andere Form des Profilstabs 14 angepaßtes Scharnierteil 49 eingesetzt werden. Das Scharnierteil 49 hat neben den Abschnitten 46, 45 noch Abschnitte 50, 51, 52, wobei der Abschnitt 52 an die Leiste 15 angeschraubt ist. Die Abschnitte 50 und 51 sind durch ein Verstärkungsteil 53 miteinander verbunden. Der Verstärkungswinkel 48 und das Zapfenaufnahmeteil 47 stimmen bei den Scharnierteilen 18 und 49 überein.

Von den Abschnitten 45 ragen kleine Vorsprünge 56 nach außen, die sich an den Wänden der Profilstäbe 2 bis 5 bzw. 14 abstützen. Die Abschnitte 43 und 45 bzw. 51 und 45 verlaufen bei den Scharnierteilen 18 und 49 vor dem Einbau parallel. Durch die Vorsprünge 56 kommt beim Einbau eine Änderung der Parallelität zustande. Dies bedeutet, daß nach dem Anschrauben der Abschnitte 43, 52 an die Leisten 13, 15 eine elastische Biegung hervorgerufen wird, durch die eine Anpreßkraft zwischen den Vorsprüngen 56 und den Profilstäben 2 bis 5 bzw. 14 entsteht. Durch die Anpreßkraft werden die Scharnierteile 18, 49 fester mit den Profilstäben 2 bis 5 bzw. 14 verbunden.

Der Anschlag 29 ist an die Form eines zwei Leisten 13 aufweisenden Profilstabs 2, 3, 4 bzw. 5 angepaßt. Er besteht aus zwei rechtwinklig zueinander abgebogenen Abschnitten 54, 55, von denen der Abschnitt 54 an die Leiste 13 angeschraubt ist. Vom Abschnitt 55 umgreift ein abgebogener Lappen 57 die eine Kante des Hohlkörpers 11 und gibt dem Anschlag 29 einen festeren Sitz.

Bei einem Profilstab 14, der nur eine vorspringende Leiste 15 enthält, ist ein etwas anders geformter Anschlag 58 vorgesehen, der drei Abschnitte 59, 60, 61 aufweist, von denen der Abschnitt 60 an der Leiste 15 angeschraubt ist. Der Abschnitt 62 enthält einen gleich ausgebildeten Lappen 57 wie der Abschnitt 55 des Anschlags 29.

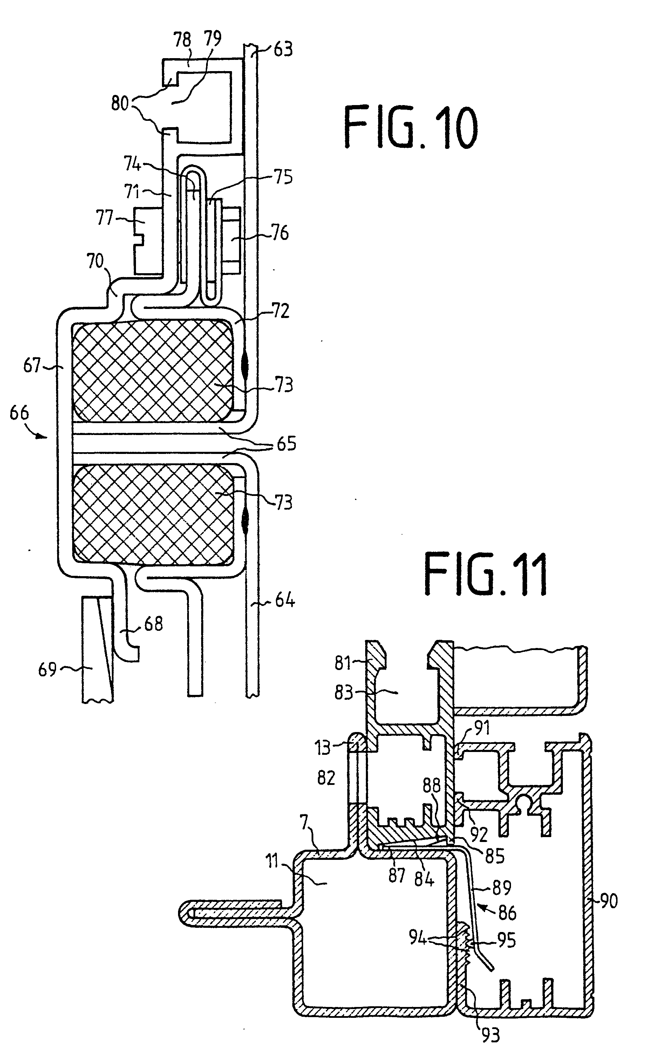

Es kann insbesondere bei breiteren Schränken vorkommen, daß zwei Türen 63, 64 verwendet werden, die sich in der Schließstellung nicht an einem vertikalen Profilstab abstützen. Ein derartiger vertikaler Profilstab kann z.B. wegen der Einbauteile des Schrankes nicht erwünscht sein. Die beiden Türen 63, 64, von denen in Fig. 10 nur jeweils das der Scharnierseite abgewandte Ende im Querschnitt dargestellt ist, weisen rechtwinklig umgebogene Ränder 65 auf. Eine Anschlagleiste 66 besteht aus einem ebenen Mittelteil 67, das an den vertikalen Rändern um 90° abgewinkelt ist und auf einer Seite in eine parallel zum Mittelteil 67 verlaufende Anschlagplatte 68 übergeht. Die Anschlagplatte 68 steht einem um eine nicht dargestellte Achse drehbaren Riegel 69 in dessen Verriegelungsstellung gegenüber. Auf der anderen Seite geht das Mittelteil 67 nach einem Z-förmig abgewinkelten Abschnitt 70 in eine ebene Platte 71 über, die parallel zum Mittelteil 67 verläuft und Löcher aufweist, die nicht näher dargestellt sind. Die Platte 71 befindet sich in einem gewissen Abstand vor der Fläche der Tür 63, an der eine in Schließstellung dem Schrankinneren zugewandte Halteleiste 72 für eine Türdichtung 73 z.B. durch Punktschweißung befestigt ist. Die Halteleiste 72 liegt mit einem nicht näher bezeichneten Abschnitt an der Fläche der Tür 63 an. Ein weiterer nicht bezeichneter Abschnitt verläuft parallel zum Rand 65 und schließt mit diesem den Raum für die Türdichtung 73 ein. An diesen Abschnitt schließt sich ein weiterer Abschnitt 74 an, der der Platte 71 gegenübersteht.

An dem Abschnitt 74 ist mit einem Halteclip 75 eine Mutter 76 befestigt, in die eine in ein Loch der Platte 71 eingesetzte Schraube 77 eingeschraubt ist.

Die Platte 71 geht an ihrem dem Mittelteil 67 abgewandten Ende in ein Profilteil 78 über, das einen quadratischen Querschnitt hat. Das Profilteil 78 liegt an einer Seite an der Rückseite der Türfläche an. Auf der gegenüberliegenden Seite des Profilteils 78 ist eine Öffnung 79 vorgesehen, die beiderseits von Vorsprüngen 80 begrenzt wird. Die Öffnung 79 hat eine geringere Breite als der Hohlraum im Profilteil 78. In den Hohlraum können Muttern oder Leisten mit Gewindebohrungen eingesetzt werden, an denen sich Teile festschrauben lassen, die mit der Tür 63 verbunden werden sollen. Bei diesen Teilen kann es sich z.B. um Taschen für Schaltpläne oder Abdeckungen für Geräte handeln, die mit der Tür 63 verbunden sind. Der Anschlag 66 stützt sich daher über das Profilteil 79 und die Platte 71 an der Tür 63 ab. Es wird eine feste Verbindung erzielt, die den von der anderen Tür 65 auf das Mittelteil 67 ausgeübten Kräften standhält.

Die Fig. 11 zeigt einen horizontalen Profilstab 7, 8, 9 oder 10 im Querschnitt, auf dem eine Verstärkungsleiste 81 aufgeschraubt ist. Es kann sich z.B. um den Profilstab 7 handeln, an dem die Verstärkungsleiste 81 mittels nicht näher dargestellter Schrauben befestigt ist. Die Verstärkungsleiste 81 ist als Stangenprofil ausgebildet. Sie weist einen geschlossenen Hohlraum 82 und einen nach oben offenen Raum 83 auf. Die Verstärkungsleiste 81 befindet sich auf der dem Schrankinneren abgewandten Seite der Leiste 13. In der Breite entspricht die Verstärkungsleiste 81 dem Abstand zwischen der Leiste 13 und der Kante des Profilstabs 7. Auf der dem Hohlkörper 11 des Profilstabs 7 zugewandten Seite ist ein zurückgesetzter Abschnitt 84 in der Verstärkungsleiste 81 vorhanden. Der Abschnitt 84 erstreckt sich in Längsrichtung der Verstärkungsleiste 81 und hat einen keilförmigen Querschnitt. Gegen die Schrankaußenseite hin wird der zurückgesetzte Abschnitt 84 von einem Vorsprung 85 abgedeckt, der an der Kante des Hohlkörpers 11 einen nicht näher bezeichneten Spalt freiläßt.

In den zurückgesetzten Abschnitt 84 ist eine Blattfeder 86 mit einem Ende 87 eingesetzt, das einen abgebogenen Lappen 88 aufweist, der sich am Vorsprung 85 abstützt. Das andere Ende 89 der Feder 86 ist in etwa rechtwinklig gegen das Ende 87 abgebogen und ragt durch den Spalt in den Raum vor dem Profilstab 7. Eine Beschriftungsleiste 90 mit rechteckigem Umriß ist als Profilstab ausgebildet, der auf einer dem Schrank zugewandten Breitseite ein oder zwei obere Auflageflächen 91, 92 und einen unteren Schenkel oder Anschlagwinkel 93 enthält. Der Anschlagwinkel 93 ist auf seiner dem Inneren der Beschriftungsleiste 90 zugewandten Seite mit parallelen Längsnuten 94 versehen. Die Blattfeder 86 hat an ihrem Ende 89 auf der dem Profilstab 7 zugewandten Seite eine Nase 95, die in die Nuten 94 einrasten kann.

Die Beschriftungsleiste 90 wird von einer Stellung unterhalb des Profilstabs 7 mit dem Anschlagwinkel 93 an den Profilstab 7 und mit den Auflageflächen 91, 92 gegen die Verstärkungsleiste 81 angelehnt. Das Ende 89 der Blattfeder 86 ragt dabei in den Hohlraum im Inneren der Beschriftungsleiste 90. Anschließend wird die Beschriftungsleiste 90 entlang der Berührungsflächen mit dem Profilstab 90 und der Verstärkungsleiste 81 nach oben geschoben, bis die Unterseiten von Profilstab 7 und Beschriftungsleiste 90 miteinander fluchten. Dabei rastet die Nase 95 in eine der Nuten 94 ein und hält damit die Beschriftungsleiste 90 am Schrank 1 fest. Zweckmäßigerweise sind längs des Profilstabs 7 mehrere Blattfedern 86 vorgesehen.

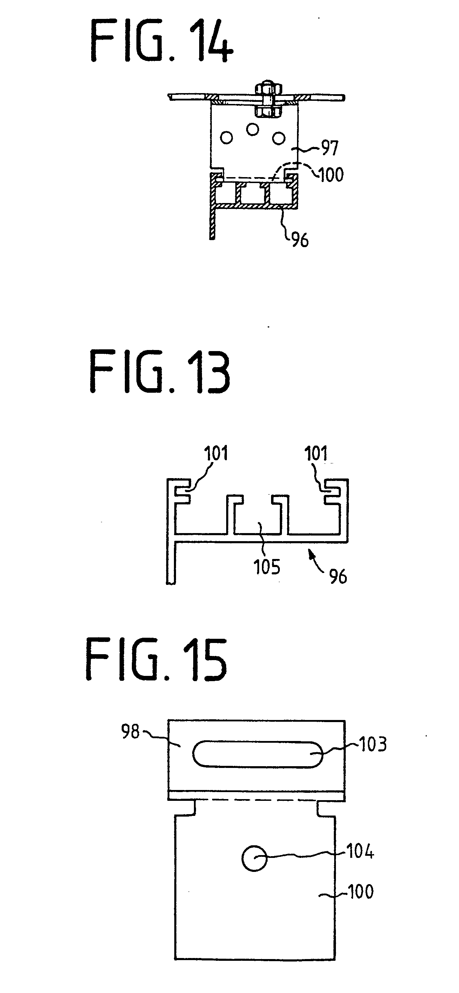

Die Fig. 12 zeigt eine Führungsschiene 96 von oben, die von Z-förmig gebogenen Winkeln 97 gehalten wird. Die Führungsschiene 96 und die Winkel 97 befinden sich im Inneren eines Schranks 1 und sind paarweise vorhanden. Auf den Führungsschienen 96 können Einschübe, Einsätze oder Geräte verschiebbar angeordnet sein. Der eine Winkel 97 ist mit einem äußeren Abschnitt 98 an der Leiste 13 des hinteren vertikalen Profilstabs 5 in den Löchern 17 festgeschraubt. Der vordere Winkel 97 ist mit seinem äußeren Abschnitt 98 an einer Tragschiene 99 angeschraubt, die ein Anschlußelement darstellt und an ihrem einen abgekröpften Ende an der Leiste 13 des vorderen vertikalen Profilstabs 2 abgeschraubt ist. An den anderen Seiten sind die Winkel 97 mit ihren Abschnitten 100 in Nuten 102 der Führungsschiene 96 eingeschoben. Daher sind die Führungsschienen 96 zum Einstellen einer gewünschten Position in ihrer Achsrichtung verschiebbar. Die beiden Abschnitte 98 und 100 verlaufen nicht genau parallel zueinander. Beim Anziehen der Befestigungsschraube 102 an der Leiste 13 des Profilstabs 5 wird der Abschnitt 100 in den Nuten 101 verkantet. Damit wird die Führungsschiene 96 festgeklemmt.

Im Abschnitt 98 ist ein senkrecht verlaufendes Langloch 103 vorgesehen, das eine stufenlose Höheneinstellung der Winkel 97 und damit der Führungsschiene 96 ermöglicht. Im Abschnitt 100 ist eine Bohrung 104 vorgesehen, der in der Führungsschiene 96 eine Nut 105 gegenübersteht, die an ihrer Öffnung zwei in Längsrichtung verlaufende Vorsprünge enthält. In die Nut 105 können Muttern oder eine Gewindeleiste eingesetzt werden, um die Winkel 97 über die Bohrungen 104 anzuschrauben. Diese zusätzliche Befestigung ist jedoch nur dann notwendig, wenn große Kräfte über die Winkel 97 und die Führungsschiene 96 übertragen werden müssen.

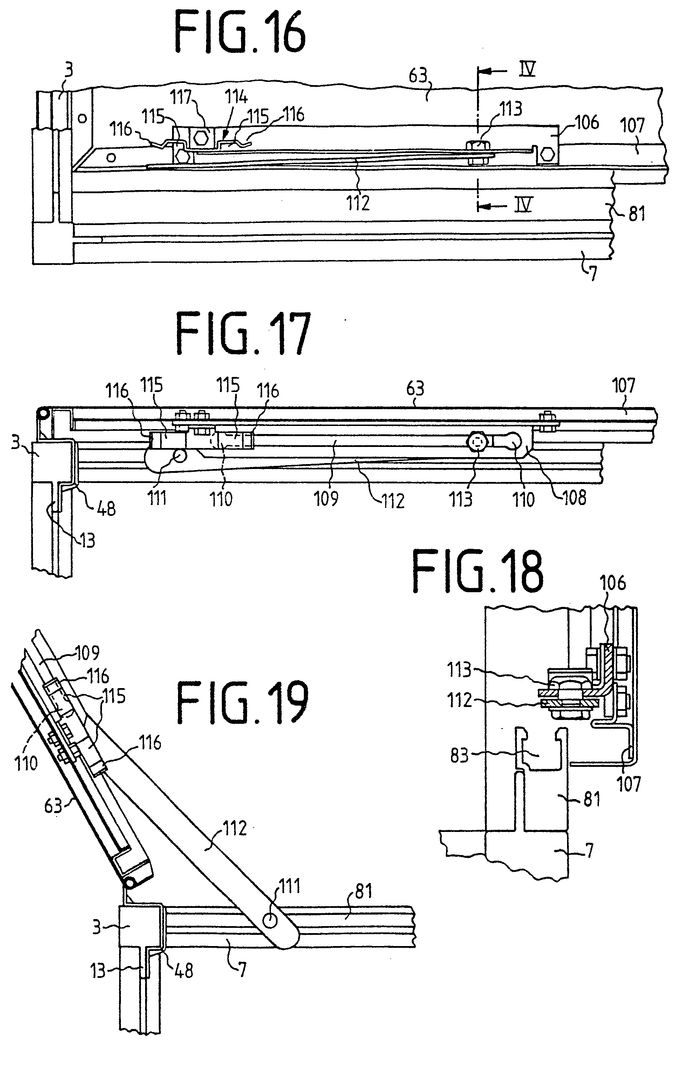

Zur Arretierung einer Tür in einer bestimmten Öffnungsstellung dient die in Fig. 16 bis 19 gezeigte Vorrichtung. Eine Tür, z.B. die Tür 63, ist mit den Scharnierteilen 48 an einem vertikalen Profilstab 3 angelenkt. Eine Schiene 106 mit L-förmigem Querschnitt ist an einer am unteren Rand der Tür 63 angeordneten horizontalen Dichtungsleiste 107 befestigt. Im horizontalen Abschnitt 108 der Schiene 106 befindet sich eine längliche Führungsbahn 109, deren Enden 110 kreisringförmig erweitert sind. Ein mit dem Profilstab 3 verbundener horizontaler Profilstab 7 trägt eine Verstärkungsleiste 81, in deren nach oben offenem Hohlraum 83 eine Schraube 111 eingesetzt ist, die eine Drehachse für einen Hebel 112 bildet, der an seinem anderen Ende einen Bolzen 113 trägt, der in die Führungsbahn 109 hineinragt und längs dieser verschiebbar ist. Der Bolzen 113 weist einen nicht näher bezeichneten, über die Führungsbahn 109 hinausragenden Kopf auf.

An der dem Profilstab 3 zugewandten Seite der Schiene 106 ist eine Blattfeder 114 befestigt. Die Blattfeder 114 ist mit einer über dem kreisförmigen Ende 110 angeordneten Wölbung 115 versehen, vor der sich eine schräge Auflauffläche 116 befindet. Die Auflauffläche ragt in den Weg, den der Kopf des Bolzens 113 beim Öffnen der Tür 63 zurücklegt. Die Blattfeder 114 weist zwei Wölbungen 115 und zwei Auflaufflächen 115 auf, die symmetrisch zur Mitte angeordnet sind. Da die Blattfeder 114 über einen seitlichen Lappen 117 angeschraubt ist, ermöglicht die symmetrische Anordnung der Wölbungen 115 und der Auflaufflächen die Verwendung gleich ausgebildeter Blattfedern 114 am oberen und unteren Profilstab bzw. für Rechts- oder Linksanschlag. Falls keine Druckfederarretierung gewünscht wird, kann auch eine Fallstiftarretierung vorgesehen werden. In diesem Falle ist der Bolzen 113 in Form eines Fallstifts auszubilden, der in der Öffnungsstellung der Tür 63 in das Ende 110 fällt. Zum Schließen der Tür 63 ist der Fallstift von Hand anzuheben, bis er sich im schmalen Teil der Führungsbahn 109 befindet. Die vorstehend beschriebene Anordnung ermöglicht die Verwendung beider Befestigungsarten mit weitgehender Beibehaltung der Teile für den Feststellmechanismus.

In Fig. 19 ist die Tür 63 in der Öffnungsstellung gezeigt, in der der Kopf des Bolzens 113 in die Wölbung 115 eingerastet ist. Die Tür 63 wird also durch die Kraft der Blattfeder 114 in ihrer Öffnungsstellung gehalten. Diese Kraft muß überwunden werden, wenn die Tür 63 wieder geschlossen werden soll.

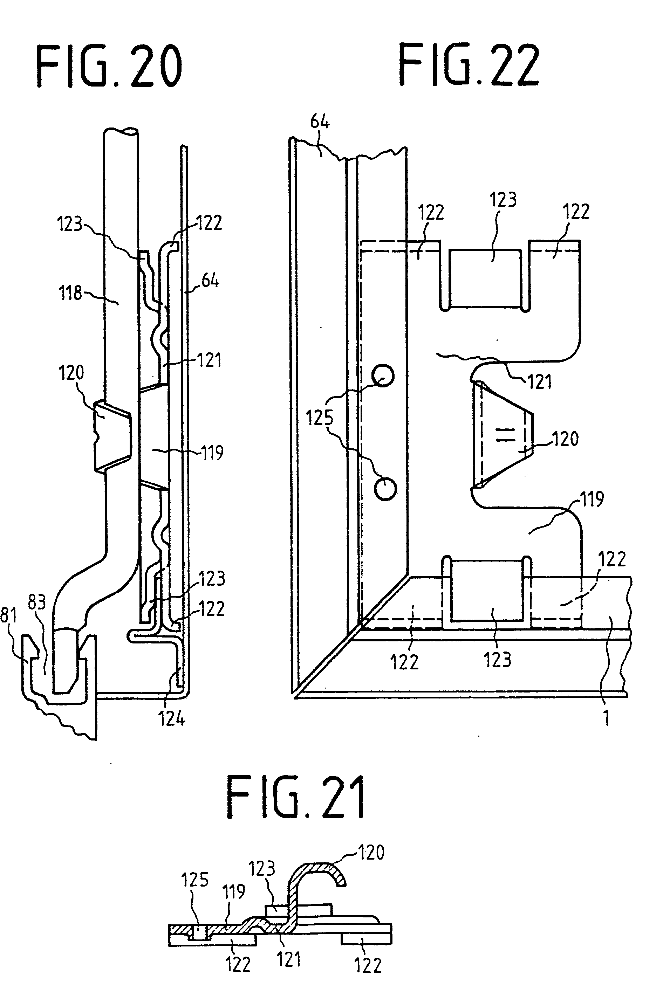

Zum Verriegeln einer Tür, z.B. der Tür 64, sind neben dem Riegel 69 noch je eine vom Schloß nach oben und nach unten ragende Stange 118 vorgesehen. Die Stangen 118 bewegen sich bei der Drehung des Schlüssels im Schloß in ihre äußeren Endlagen, in denen die Enden 119 in die Hohlräume 83 von Verstärkungsleisten 81 ragen. Die Stangen 118, von denen in Fig. 20 nur eine dargestellt ist, werden von Führungskörpern 119 gehalten, die gekrümmte Lappen 120 aufweisen, die mit ihren wenigstens einen Halbkreis bildenden Enden die Stangen 118 umgreifen. Die Führungskörper 119 sind mit plattenartigen Basisteilen 121 versehen, die an zwei einander gegenüberliegenden Seiten gabelförmige Enden 122, 123 aufweisen. Die gabelförmigen Enden 122, 123 an einer Seite des Führungskörpers 119 sind auf die vertikale Dichtungsleiste 124 der Tür 64 aufgesteckt. In dem Basisteil 121 befinden sich noch Löcher 125, in die nicht dargestellte Schrauben zum Befestigen des Führungskörpers 119 an der Tür 64 eingesetzt werden.

Die Anschlußelemente 22, 97, 99 für die Geräte, Einschübe oder Einsätze sind an ihren Enden vorzugsweise mit einzelnen Vorsprüngen versehen, die Löcher für das Einstecken von Schrauben aufweisen, wobei zwischen den Vorsprüngen freie Räume verbleiben, die das Einsetzen von Schrauben in die nicht den Vorsprüngen zugeordneten Löcher ermöglichen. Werden Anschlußelemente an den Löchern 17 der ersten Reihe befestigt, dann werden hiervon nicht die Löcher 18 der zweiten Reihe für die an diese anzuschließenden Teile blockiert. Umgekehrt gilt das geiche.

## Patentansprüche

1. Schrank zur Aufnahme von Einsätzen, Einschüben und Geräten, die elektrische und/oder elektronische Bauelemente aufweisen, mit einem Rahmengestell aus mindestens zwölf miteinander verbundenen Rahmenschenkeln aus Profilstäben, die den gleichen Querschnitt haben und als quadratische Hohlkörper ausgebildet sind, die auf mindestens einer Längsseite eine sich in Längsrichtung erstreckende, rechtwinklig vorspringende Leiste aufweisen, die mit einer Reihe von Löchern versehen ist, an denen die Einsätze, Einschübe oder Geräte gegebenenfalls über Anschlußelemente befestigbar sind, dadurch gekennzeichnet, daß die Leiste (13, 15) neben den Löchern (17) der ersten Reihe, deren Abstände einem für Einbauteile vorgesehenen Rastermaß entsprechen, mit einer zweiten Reihe von Löchern (18) versehen ist, die parallel zu der ersten Reihe von Löchern (17) angeordnet und gegen diese in Längsrichtung versetzt sind, daß die Löcher (18) der zweiten Reihe über Zwischenstücke (26), die an ihrer dem Schrankinneren abgewandten Seite angeordnet sind, mit Wänden (25) verbunden sind und daß an den Löchern (18) der zweiten Reihe jeweils an einem Loch Scharnierteile (28, 49) für Türen (63, 64) mit dem Umriß der Profilstäbe (2 bis 10, 14, 31, 32, 15) angepaßten, bis zu den Leisten (13) verlaufenden Abschnitten (43, 52) und/oder Anschlägen (29, 58) befestigbar sind.

2. Schrank nach Anspruch 1, dadurch gekennzeichnet, daß die Profilstäbe aus einem Blechstreifen durch Biegung, Umbördelung und Lochstanzung hergestellt sind.

3. Schrank nach Anspruch 1 oder 2, dadurch gekennzeichnet, daß das Rastermaß der ersten Reihe von Löchern (17), die in der Leiste (13, 15) zwischen der Reihe der zweiten Löcher (18) und dem Hohlprofil (12) angeordnet sind, fünfundzwanzig Millimeter ist.

4. Schrank nach einem der vorausgehenden Ansprüche, dadurch gekennzeichnet, daß als Zwischenträger (30) ein oder zwei Profilstäbe (31, 32) nebeneinander vertikal an ihren Enden mit horizontalen Profilstäben (7) durch Formstücke (33) verbunden sind, die je einen in den Hohlraum eines Profilstabs (31, 32) formschlüssig hineinragenden Zapfen (34) mit einem Basisteil (35) aufweisen, das sowohl an der Leiste (13) des horizontalen als auch an der Leiste des vertikalen Profilstabs (7, 31, 32) angeschraubt ist.

5. Schrank nach Anspruch 4, dadurch gekennzeichnet, daß vom Basisteil (35) ein Vorsprung (39) ausgeht, der sich in zwei parallele Zungen (40) gabelt, die durch einen Abstand voneinander getrennt sind, in den jeweils die Leiste (13) des vertikalen Profilstabs (31, 32) ragt.

6. Schrank nach einem der vorausgehenden Ansprüche, dadurch gekennzeichnet, daß Anschlußelemente (22, 99) für die Verbindung der Profilstäbe (2 bis 10, 14, 31, 32) mit Einbaugeräten oder Einbaugeräteträgern an ihren Enden (23) um die Stärke der Leisten (13, 15) der Profilstäbe (2 bis 10, 14, 31, 32) abgekröpft sind, wobei die abgekröpften Enden (23) jeweils mindestens zwei Lappen aufweisen, die durch einen Löcher der ersten Reihe freigebenden Abstand voneinander getrennt und an der dem Schrankinneren abgewandten Seite an den Leisten (13) mittels der Löcher (18) der zweiten Reihe angeschraubt sind.

7. Schrank nach einem der vorausgehenden Ansprüche, dadurch gekennzeichnet, daß eine über einen abgebogenen Rand (65) der scharnierlosen, vertikalen Seite einer Tür (63) hinausragende Anschlagleiste (66) an einer Halteleiste (72) für eine Türdichtung (73) angeschraubt ist und daß der über die Tür (63) hinausragende Teil der Anschlagleiste (66) in Schließstellung an den abgebogenen Rand (65) der scharnierlosen vertikalen Seite einer zweiten Tür (64) angelehnt ist, die ein Schloß aufweist, dessen Riegel (69) in Schließstellung gegen einen abgekröpften Vorsprung (68) der Anschlagleiste (66) andrückbar ist.

8. Schrank nach Anspruch 7, dadurch gekennzeichnet, daß die Anschlagleiste (66) eine mit der Halteleiste (72) verbundene Platte (71) aufweist, an die sich ein Profilteil (78) anschließt, das sich an der Innenseite der Tür (63) abstützt.

9. Schrank nach einem der vorausgehenden Ansprüche, dadurch gekennzeichnet, daß an den Leisten (13) der horizontalen Profilstäbe (6, 7, 8, 9, 10) auf der dem Schrankinneren abgewandten Seite Verstärkungsleisten (81) angeschraubt sind, die in der Stärke dem Abstand zwischen der Leiste (13) und der Kante des jeweiligen Profilstabs angepaßt sind und die auf ihrer, dem jeweiligen Profilstab zugewandten Seite einen hohlen zurückgesetzten Abschnitt (84) mit einem längs der Kante verlaufenden Vorsprung (85) aufweisen, wobei in den zurückgesetzten Abschnitt (84) eine Blattfeder (86) eingelegt ist, die ein aus dem Abschnitt herausragendes abgewinkeltes Ende (89) enthält, das im Abstand vor der Profilleiste (7) angeordnet ist und einen Schenkel (93) einer Beschriftungsleiste (90) an der Profilleiste (7) anklemmt.

10. Schrank nach Anspruch 9, dadurch gekennzeichnet, daß die Beschriftungsleiste (90) auf ihrer der Verstärkungsleiste (81) zugewandten Seite mit Auflageflächen (91, 92) an die Verstärkungsleiste (81) angelehnt ist.

11. Schrank nach Anspruch 9 oder 10, dadurch gekennzeichnet, daß der Schenkel (93) auf seiner dem Inneren der Beschriftungsleiste (90) zugewandten Seite parallele Längsnuten (94) enthält, in die eine Nase (95) einrastbar ist, die am Ende (89) der Blattfeder (86) angeordnet ist.

12. Schrank nach einem der vorausgehenden Ansprüche, dadurch gekennzeichnet, daß an den Leisten (13) der vertikalen Profilstäbe (2, 3, 4, 5, 31, 32) und/oder an zwischen den Profilstäben angeordneten Anschlußelementen (99) Z-förmig gebogene Winkel (97) an einer Seite angeschraubt sind, wobei die andere Seite jeweils in einer Nut (101) einer Führungsschiene (96) angeordnet ist, die Einschübe, Einsätze oder Geräte trägt.

13. Schrank nach Anspruch 12, dadurch gekennzeichnet, daß die beiden äußeren Abschnitte (98, 100) der Winkel (97) unter einer geringen Neigung zueinander angeordnet sind.

14. Schrank nach Anspruch 12 oder 13, dadurch gekennzeichnet, daß die den Profilstäben (2, 3, 4, 5, 31, 32) zugewandten äußeren Abschnitte (98) der Winkel (97) vertikale Langlöcher (103) aufweisen.

15. Schrank nach einem der vorausgehenden Ansprüche, dadurch gekennzeichnet, daß an der Innenseite nahe am oberen oder unteren Rand einer Tür (63) des Schranks (1) eine Schiene (106) befestigt ist, in deren Führungsbahn (109) ein am Ende eines Hebelarms (112) befestigter Bolzen (113) verschiebbar angeordnet ist, wobei der Hebelarm (112) an einem horizontalen Profilstab oder an einer horizontalen Verstärkungsleiste (81) in einer Ebene schwenkbar gelagert ist und wobei der Bolzen (113) einen über die Führungsleiste (109) hinausragenden Kopf aufweist, der in eine am Ende der Führungsbahn angeordnete Wölbung (115) einer Blattfeder (114) einrastbar ist.

16. Schrank nach Anspruch 15, dadurch gekennzeichnet, daß die Blattfeder (114) an einen unter 90° abgewinkelten Lappen an einer Halteleiste für Dichtungen angeschraubt ist und daß die Blattfeder (114) zwei symmetrisch zur Mitte angeordnete Wölbungen (115) und vor den Wölbungen schräge Auflaufflächen (116) aufweist.

17. Schrank nach einem der vorausgehenden Ansprüche, dadurch gekennzeichnet, daß vertikale, in axialer Richtung mittels eines Schlüssels verschiebbare Stangen (118) je an einem Ende in einem Schloß einer Tür (64) und am anderen Ende in einem wenigstens einen Halbkreis beschreibenden Lappen (120) eines Führungskörpers (119) gelagert sind, der zwei gabelförmig gebogene Enden (112, 123) aufweist, die an einer Seite des Führungskörpers (119) in mit der Tür (64) verbundene Halteleisten (124) für Dichtungen eingesteckt sind, während der vertikale Rand des Führungskörpers an der vertikalen Halteleiste für Dichtungen angeschraubt ist.

**Claims**

1. Cabinet for the reception of inserts, modules and devices, which display electrical and/or electronic components, with a framework consisting of at least twelve interconnected frame limbs of profile rods which have the same cross-section and are constructed as square hollow bodies which on at least one longitudinal side display a strip which extends in longitudinal direction, projects at right angles and is provided with a row of holes, at which the inserts, modules or devices are fastenable, in a given case by way of connecting elements, characterised thereby, that the strip (13, 15), apart from the holes (17) of the first row, the spacings of which correspond to a grid spacing envisaged for built-in parts, is provided with a second row of holes (18), which is arranged parallelly to the first row of holes (17) and displaced in longitudinal direction relative to these, that the holes (18) of the second row are connected with walls (25) by way of intermediate pieces (26), which are arranged at their side remote from the interior of the cabinet, and that hinge parts (28, 49) for doors (63, 64) with portions (43, 52) and/or abutments (29, 58), which are matched to the outline of the profile rods (2 to 10, 14, 31, 32, 15) and extend as far as the strips (13), are fastenable at a respective hole at the holes (18) of the second row.

2. Cabinet according to claim 1, characterised thereby, that the profile rods are produced out of a sheet metal strip through bending, flanging and hole-punching.

3. Cabinet according to claim 1 or 2, characterised thereby, that the grid spacing of the first row of holes (17), which are arranged in the strip (13, 15) between the row of second holes (18) and the hollow profile (12), is twenty-five millimetres.

4. Cabinet according to one of the preceding claims, characterised thereby, that one or two profile rods (31, 32) each vertically beside the other are as intermediate carriers (30) connected at their ends with horizontal profile rods (7) through shaped pieces (33), which each display a respective spigot (34) shape-lockingly projecting into the hollow space of a profile rod (31, 32) with a base part (35), which is screwed to the strip (13) of the horizontal profile rod (7) as well as also to the strip of the vertical profile rod (31, 32).

5. Cabinet according to claim 4, characterised thereby, that a projection (39) extends from the base part (35) and forks into two parallel tongues (40), which are each separated from the other y a spacing, into which the strip (13) of the vertical profile rod (31, 32) projects each time.

6. Cabinet according to one of the preceding claims, characterised thereby, that connecting elements (22, 99) for the connection of the profile rods (2 to 10, 14, 31, 32) with built-in devices or carriers for built-in devices are offset at their ends (23) by the thickness of the strips (13, 15) of the profile rods (2 to 10, 14, 31, 32), wherein the offset ends (23) each display at least two lobes which are separated each from the other by a spacing which frees holes of the first row and screwed by means of the holes (18) of the second row to the strips (13) at the side remote from the interior of the cabinet.

7. Cabinet according to one of the preceding claims, characterised thereby, that an abutment strip (66), which projects beyond a bentover edge (65) of the hingeless vertical side of a door (63), is screwed to a retaining strip (72) for a door seal (73) and that the part of the abutment strip (66), which projects beyond the door (63), in closed setting is leaned against the bent-over edge (65) of the hingeless vertical side of a second door (64), which displays a lock, the bolt (69) of which is pressable in closed setting against an offset projection (68) of the abutment strip (66).

8. Cabinet according to claim 7, characterised thereby, that the abutment strip (66) displays a plate (71), which is connected with the retaining strip (72) and adjoined by a profile part (78), which bears against the inside of the door (63).

9. Cabinet according to one of the preceding claims, characterised thereby, that re-inforcing strips (81) are screwed to the side remote from the interior of the cabinet to the strips of the horizontal profile rods (6, 7, 8, 9, 10), are matched in thickness to the spacing between the strip (13) and the edge of the respective profile rod and at their side facing the respective profile rod display a recessed portion (84) with a projection (85) extending along the edge, wherein a leaf spring (86) is laid into the recessed portion (84) and contains a bent-over end (89), which projects out of the portion, is arranged at a spacing before the profile strip (7) and clamps a limb (93) of an inscription strip (90) to the profile strip (7).

10. Cabinet according to claim 9, characterised thereby, that the inscription strip (90) on its side facing the re-inforcing strip (81) is leaned by bearing surfaces (91, 92) against the re-inforcing strip (81).

11. Cabinet according to claim 9 or 10, characterised thereby, that the limb (93) on its side facing the interior of the inscription strip (90) contains parallel longitudinal grooves (94), into which a lug (95) is detentable, which is arranged at the end (89) of the leaf spring (86).

12. Cabinet according to one of he preceding claims, characterised thereby, that brackets (97) bent into Z-shape are screwed at one side to the strips (13) of the vertical profile rods (2, 3, 4, 5, 31, 32) and/or to connecting elements (99) arranged between the profile rods, wherein the other side is arranged in a respective groove (101) of a guide rail (96), which carries modules, inserts or devices.

13. Cabinet according to claim 12, characterised thereby, that both the outer portions (98, 100) of the brackets (97) are arranged each at a slight inclination to the other.

14. Cabinet according to claim 12 or 13, characterised thereby, that the outer portions (98), facing the profile rods (2, 3, 4, 5, 31, 32), of the brackets (97) display vertical elongate holes (103).

15. Cabinet according to one of the preceding claims, characterised thereby, that fastened at the inside near to the upper or lower edge of a door (63) of the cabinet (1) is a rail (106), in the guide track (109) of which a pin (113) fastened at the end of lever arm (112) is arranged to be displaceable, wherein the lever arm (112) is borne at a horizontal profile rod or at a horizontal re-inforcing strip (81) to be pivotable in one plane and wherein the pin (113) displays a head which projects beyond the guide strip (109) and is detentable in a concavity (115), arranged at the end of the guide track, of a leaf spring (114).

16. Cabinet according to claim 15, characterised thereby, that the leaf spring (114) is screwed to a retaining strip for seals at a lobe bent over by less than 90° and that the leaf spring (114) displays two concavities (115) arranged symmetrically of the centre and inclined ramp surfaces (116) in front of the concavities.

17. Cabinet according to one of he preceding claims, characterised thereby, that vertical rods (118), which are displaceable in axial direction by means of a key, are each borne at one end in a lock of a door (64) and at the other end in a lobe (120), describing at least a semicircle, of a guide body (119), which displays two ends (112, 113), which are bent in fork shape and at one side of the guide body (119) plugged into retaining strips (124), connected with the door (64), for seals, whilst the vertical edge of the guide body is screwed to the vertical retaining strip for seals.

**Revendications**

1. Armoire qui est destinée à recevoir des éléments d'insertion et des appareils comportant des composants électriques et/ou électroniques et qui comprend un châssis de cadre formé d'au moins douze éléments de cadre reliés les uns aux autres et constitués par des barres profilées qui ont toutes la même section transversale et sont des corps creux parallélépipédiques qui, sur l'un au moins de leurs côtés longitudinaux, portent une nervure en forme de bande qui fait saillie dans le sens perpendiculaire et s'étend dans le sens longitudinal et qui comporte une série de trous dans lesquels les éléments d'insertion ou les appareils peuvent être fixés, le cas échéant par l'intermédiaire d'éléments de liaison, caractérisée en ce que la bande (13, 15) comporte, à côté des trous (17) de la première série, dont l'écartement correspond à un module adapté aux éléments de construction, une deuxième rangée de trous (18) qui sont disposés parallèlement à la première rangée de trous (17) et sont décalés par rapport à elle dans le sens de la longueur, en ce que les trous (18) de la deuxième rangée sont reliés à des parois (25) par l'intermédiaire de pièces intercalaires (26) sont placées sur leur côté le plus éloigné de l'intérieur de l'armoire et en ce que des pièces de charnière (28, 49) pour portes (63, 64) peuvent être fixées aux trous (18) de la deuxième rangée et comportent des secteurs (43, 52) adaptés au contour des barres profilées (2 à 10, 14, 31, 32, 15) et allant jusqu'aux bandes (13) et/ou des butées (29, 58).

2. Armoire selon la revendication 1, caractérisée en ce que les barres profilées sont fabriquées à partir d'une bande de tôle par pliage, rabattement de bords et estampage de trous.

3. Armoire selon l'une des revendications 1 ou 2, caractérisée en ce que le module d'écartement pour la première rangée de trous (17) qui sont ménagés dans la bande (13, 15) entre la rangée des deuxièmes trous (18) et le profilé creux (12), est de vingt-cinq millimètres.

4. Armoire selon l'une des revendications précédentes, caractérisée en ce que les supports intermédiaires (30) sont constitués par une barre profilée ou par deux barres profilées (31, 32) disposées verticalement l'une à côté de l'autre et reliées, à leurs extrémités, à des barres profilées horizontales (7) par des pièces de moulage (33) qui comportent chacune un tenon (34) qui s'engage par encastrement dans la cavité d'une barre profilée (31, 32) et comprend une partie de base (35) qui est vissée à la fois sur la bande (13) de la barre profilée horizontale et sur la bande de la barre profilée verticale (7, 31, 32).

5. Armoire selon la revendication 4, caractérisée en ce qu'une partie saillante (39) partant de la partie de base (35) se subdivise en deux languettes parallèles (40) qui sont séparées l'une de l'autre par un intervalle dans lequel dépasse la bande (13) de la barre profilée verticale (31, 32).

6. Armoire selon l'une des revendications précédentes, caractérisée en ce que les éléments de raccord (22, 99) qui assurent la liaison entre les barres profilées (2 à 10, 14, 31, 32) et les appareils mis en place ou les supports de ces appareils sont, au niveau de leurs extrémités (23), déformés d'une quantité correspondant à l'épaisseur des bandes (13, 15) des barres profilées (2 à 10, 14, 31, 32), ces extrémités déformées (23) comportant chacune au moins deux pattes qui sont séparées l'une de l'autre par une distance dégageant des trous de la première rangée et sont vissés sur le côté des bandes (13) le plus éloigné de l'intérieur de l'armoire au moyen des trous (18) de la deuxième rangée.

7. Armoire selon l'une des revendications précédentes, caractérisée en ce qu'une bande de butée (66) qui dépasse à l'extérieur un bord replié (65) du côté vertical sans charnière d'une porte (63) est vissée à une bande de maintien (72) d'un joint de porte (73) et en ce que la partie de la bande de butée (66) qui dépasse à l'extérieur la porte (63) prend appui, en position de fermeture, sur le bord replié (65) du côté vertical sans charnière d'une deuxième porte (64) qui comporte une serrure dont le verrou (69) peut, en position de fermeture, s'appuyer contre une partie saillante déformée (68) de la bande de butée (66).

8. Armoire selon la revendication 7, caractérisée en ce que la bande de butée (66) comporte une plaque (71) qui est reliée à la bande de maintien (72) et qui se raccorde à une partie profilée (78) qui prend appui sur le côté intérieur de la porte (63).

9. Armoire selon l'une des revendications précédentes, caractérisée en ce que les bandes (13) des barres profilées horizontales (6, 7, 8, 9, 10) portent, vissées sur leur côté le plus éloigné de l'intérieur de l'armoire, des bandes de renforcement (81) dont l'épaisseur est adaptée à la distance comprise entre la bande (13) et le bord de la barre profilée et qui, sur leur côté tourné vers la barre profilée correspondante, comportent un secteur en retrait (84) creux présentant une partie saillante (85) orientée le long du bord, ce secteur en retrait (84) contenant un ressort lame 86 qui comporte une extrémité (89) coudée en angle, sortant du secteur, qui se trouve à une certaine distance de la bande profilée (7) et fixe à la bande profilée (7) l'une des branches (93) d'une bande (90) destinée à des inscriptions.

10. Armoire selon la revendication 9, caractérisée en ce que la bande (90) destinée à des inscriptions prend appui, de son côté tourné vers la bande de renforcement (81) et comportant des surfaces de contact (91, 92), sur la bande de renforcement (81).

11. Armoire selon l'une des revendications 9 ou 10, caractérisée en ce que la branche (93) contient, sur son côté tourné vers l'intérieur de la bande (90) destinée à des inscriptions, des rainures longitudinales parallèles (94) dans lesquelles peut s'engager un bac (95) placé à l'extrémité (89) du ressort lame (86).

12. Armoire selon l'une des revendications précédentes, caractérisée en ce que les bandes (13) des barres profilées verticales (2, 3, 4, 5, 31, 32) et/ou des éléments de raccord (99) intercalés entre les barres profilées portent, vissées sur eux d'un côté, des cornières (97) pliées en forme de Z, l'autre côté étant placé dans une rainure (101) d'un rail de guidage (96) qui porte des éléments d'insertion ou des appareils.

13. Armoire selon la revendication 12, caractérisée en ce que les deux secteurs extérieurs (98, 100) des cornières (97) sont légèrement inclinés l'un par rapport à l'autre.

14. Armoire selon l'une des revendications 12 ou 13, caractérisée en ce que les secteurs extérieurs (98) des cornières (97) qui se trouvent du côté des barres profilées (2, 3, 4, 5, 31, 32) comportent des trous oblongs verticaux (103).

15. Armoire selon l'une des revendications précédentes, caractérisée en ce que le côté intérieur situé à proximité du bord supérieur et du bord inférieur d'une porte (63) de l'armoire (1) porte, fixé sur lui, un rail (106) sur le trajet de guidage (109) duquel peut s'engager un boulon (113) qui est fixé à l'extrémité d'un bras de levier (112), ce bras de levier (112) étant monté sur une barre profilée horizontale ou sur une bande de renforcement horizontale (81) de manière à pouvoir pivoter dans un plan et le boulon (113) comportant une tête qui dépasse à l'extérieur de la bande de guidage (109) et qui peut s'engager dans la partie incurvée (115) d'un ressort (114) située à l'extrémité du trajet de guidage.

16. Armoire selon la revendication 15, caractérisée en ce que le ressort lame (114) est vissé à une patte pliée à 90° d'une bande de maintien de joints et en ce que le ressort lame (114) comporte deux parties incurvées (115) disposées symétriquement par rapport au milieu et des surfaces d'accès (116) disposées obliquement en avant des parties incurvées.

17. Armoire selon l'une des revendications précédentes, caractérisée en ce que les tiges verticales (118) qui peuvent être déplacées au moyen d'une clé dans le sens axial sont montées à l'une de leurs extrémités dans une serrure d'une porte (64) et à leur autre extrémité dans la patte ('120), au moins semi-circulaire, d'un corps de guidage (119) qui comporte deux extrémités (112, 123) incurvées en forme de fourches qui, d'un côté du corps de guidage (119), s'engagent dans des bandes de maintien (124) de joints reliées à la porte (64) tandis que le bord vertical du corps de guidage est vissé à la bande de maintien verticale des joints.

# FIG.1

FIG.2

FIG.3

# FIG.4

# FIG.5

# FIG.12

0 151 478

# FIG.6

# FIG.7

# FIG.8

# FIG.9

FIG.10

FIG.11

# FIG. 14

# FIG. 13

# FIG. 15

0 151 478

# FIG.16

# FIG.17

# FIG.18

# FIG.19

# FIG.20

# FIG.22

# FIG.21